# FASCICULE DE BREVET EUROPEEN

(11) **EP 0 841 670 B1**
(45) Date de publication et mention de la délivrance du brevet: **18.07.2001**
(21) Numéro de dépôt: 97410124.8
(22) Date de dépôt: 27.10.1997
(51) Int. Cl.: H01F 38/30, H01F 29/10

(54) **Transformateur de courant, déclencheur et disjoncteur comportant un tel transformateur**
Stromwandler, Auflöser und Schutzschalter mit solchem Stromwandler
Current transformer, trip device and circuit breaker comprising such a transformer

(30) Priorité: 07.11.1996 FR 9613833
(43) Date de publication de la demande: 13.05.1998
(73) Titulaire: Schneider Electric Industries SA, 92500 Rueil-Malmaison (FR)
(72) Inventeur: Serpinet, Marc, Schneider Electric, 38050 Grenoble (FR); Previeux, Laurent, Schneider Electric, 38050 Grenoble (FR)
(74) Mandataire: Jouvray, Marie-Andrée

(56) Documents cités:
- DE-C- 432 812
- DE-C- 716 399
- FR-A- 2 733 376
- US-A- 3 932 791
- US-A- 5 495 219

## Description

L'invention concerne un transformateur de courant comportant un circuit magnétique associé à un conducteur primaire, et un enroulement secondaire destiné à fournir un courant secondaire pour actionner un relais de déclenchement.

Les transformateurs de courant de types connus transforment un courant primaire de forte intensité, circulant dans un conducteur d'un réseau à protéger, en un courant secondaire alimentant des circuits et un relais de déclenchement. Ces transformateurs fonctionnent généralement avec des courants alternatifs. Dans certains déclencheurs, le courant secondaire alternatif est aussi utilisé pour fournir un signal de mesure à des circuits de protection.

Pour des réseaux à courant continu, les transformateurs de types connus ne permettent pas de fournir efficacement un signal de mesure ni de l'énergie suffisante pour alimenter des circuits ou un relais de déclenchement. Dans ce cas, une alimentation auxiliaire en tension et un dispositif supplémentaire de mesure du courant sont nécessaires. Cependant, un court-circuit important peut se produire près d'un disjoncteur comportant une alimentation auxiliaire. La tension du réseau peut alors baisser et provoquer une diminution de la tension fournie par l'alimentation auxiliaire. Une telle diminution peut provoquer des défauts de déclenchement des déclencheurs et être insuffisante pour alimenter le relais de déclenchement pour ouvrir le disjoncteur.

Les transformateurs peuvent fournir un courant secondaire lorsque la variation du courant primaire est importante, même lorsque ledit courant primaire a une polarité continue. Le courant secondaire dépend de la variation du courant primaire. Il peut être utilisé pour actionner un relais de déclenchement d'un disjoncteur si ladite variation est importante. Cependant, un tel déclenchement sur court-circuit ne se fait qu'a partir d'une valeur élevée de la dérivée du courant primaire.

L'invention a pour but un transformateur de courant, notamment pour courant continu, fournissant un courant secondaire lorsque le courant primaire dépasse une valeur prédéterminée, ainsi qu'un déclencheur et un disjoncteur comportant un tel transformateur.

Selon l'invention, le circuit magnétique du transformateur comporte une partie mobile et une partie fixe, la partie mobile ayant une première position ouverte ouvrant le circuit magnétique avec un entrefer de distance élevée et une seconde position fermée fermant le circuit magnétique avec un entrefer petit ou nul, ladite partie mobile passant de la première position ouverte à la seconde position fermée lorsqu'un courant primaire circulant dans le conducteur primaire dépasse une valeur prédéterminée.

Dans un mode de réalisation préférentiel de l'invention, le transformateur comporte des moyens de réglage comportant un shunt magnétique à entrefer disposé en dérivation sur la partie mobile du circuit magnétique.

Selon un premier mode de réalisation particulier, la partie mobile est une palette reliée à un ressort de rappel, ladite palette étant positionnée dans sa première position ouverte par des moyens d'appui, et positionnée dans sa seconde position fermée en contact avec une partie fixe du circuit magnétique.

Selon un second mode de réalisation particulier, la partie mobile est un noyau coulissant par rapport à une première partie fixe du circuit magnétique, ledit noyau ayant un entrefer de distance élevée par rapport à une seconde partie fixe du circuit magnétique lorsqu'il est dans sa première position ouverte et un entrefer faible ou nul par rapport à ladite seconde partie fixe lorsqu'il est dans sa seconde position fermée.

De préférence, une bobine de l'enroulement secondaire est disposée autour du noyau coulissant.

Pour de forts courants du conducteur primaire, le circuit magnétique comporte des entrefers répartis.

Un déclencheur selon l'invention, comporte au moins un transformateur et un relais de déclenchement connecté à un enroulement secondaire dudit transformateur.

Dans un mode de réalisation, un déclencheur comporte des moyens de détection associés au transformateur pour détecter le déplacement de la partie mobile du circuit magnétique, lesdits moyens étant connectés au relais de déclenchement pour contrôler l'actionnement du relais lorsqu'un courant secondaire est fourni par le transformateur.

De préférence, le déclencheur comporte une unité de traitement connecté au relais de déclenchement et, des moyens de mesure, associés au transformateur et connectés à l'unité de traitement, fournissant un signal représentatif d'un courant circulant dans le conducteur primaire.

Un disjoncteur selon l'invention comporte au moins un transformateur et des organes de réglage reliés au transformateur pour régler la valeur de courant prédéterminée pour laquelle la partie mobile passe de sa première position ouverte à sa seconde position fermée.

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- La figure 1 représente un schéma bloc d'un disjoncteur comportant un déclencheur et des transformateurs de types connus.
- La figure 2 représente un schéma d'un transformateur selon un premier mode de réalisation de l'invention.
- La figure 3 représente des courbes de fonctionnement d'un transformateur selon un mode de réalisation de l'invention.
- Les figures 4 et 5 représentent des vues d'un transformateur selon un second mode de réalisation de l'invention.
- Les figures 6 et 7 représentent des vues d'un transformateur selon une variante du mode de réalisation des figures 4 et 5.
- La figure 8 représente un schéma d'un transformateur selon un mode de réalisation de l'invention comportant un réglage de seuil.
- La figure 9 représente une vue d'un transformateur selon la figure 8 comportant un réglage de seuil.
- La figure 10 représente un schéma d'un transformateur selon un mode de réalisation de l'invention comportant un capteur sensible à une grandeur magnétique.
- Les figures 11 et 12 représentent des vues d'un transformateur selon la figure 10 comportant des entrefers répartis.

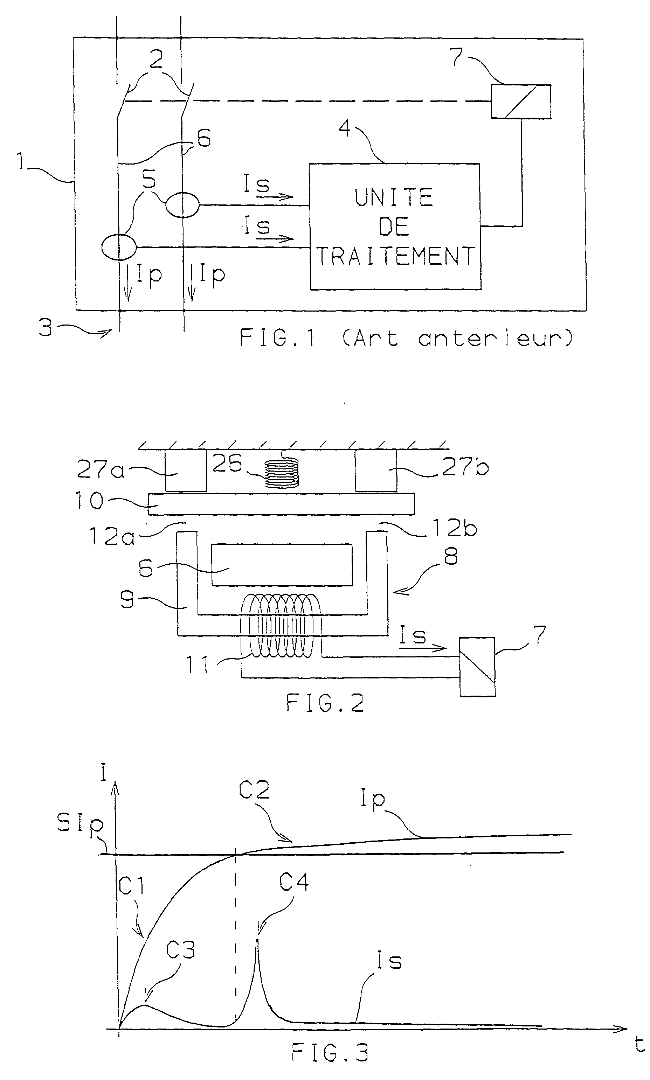

Sur le schéma de la figure 1, un disjoncteur 1 de l'état de l'art comporte des contacts 2 pour établir ou interrompre la circulation de courant électrique dans un réseau 3 à protéger. Le disjoncteur comporte aussi une unité de traitement 4 recevant un courant secondaire Is fourni par des transformateurs 5 de courant disposés sur des conducteurs primaires 6 alimentant le réseau 3.

L'unité de traitement 4 traite le signal de courant secondaire et commande un relais 7 de déclenchement lorsque ledit signal dépasse un seuil prédéterminé pendant un temps prédéterminé. Le relais 7 actionne l'ouverture des contacts 2 à travers un mécanisme d'ouverture.

Les transformateurs de courants 5 fournissent le signal de mesure et l'énergie nécessaire pour le fonctionnement de l'unité de traitement et le relais. Généralement, les transformateurs de type connu fonctionnent bien si le courant qui traverse leur conducteur primaire est alternatif. Mais, si le courant primaire est continu, le courant fourni pour l'unité de traitement et la commande du relais n'est pas suffisant.

L'alimentation de l'unité centrale peut être assurée par un circuit d'alimentation auxiliaire. Cependant, des fonctions de déclenchement instantané sur court-circuit doivent pouvoir être effectuées même en absence d'alimentations auxiliaires.

La figure 2 montre un mode de réalisation d'un transformateur selon l'invention pouvant fournir de l'énergie à un relais sans utiliser d'alimentation auxiliaire. Ce type de transformateur est particulièrement adapté aux courants à polarité continue mais il peut aussi être utilisé en courant alternatif.

Le transformateur de la figure 2 comporte un circuit magnétique 8 comportant une partie fixe 9 et une partie mobile 10. L'ensemble du circuit magnétique entoure un conducteur primaire 6 dans lequel circule un courant Ip d'un réseau à protéger. Un enroulement 11 secondaire bobiné sur une partie du circuit magnétique 8, est connecté au relais de déclenchement 7.

La partie mobile du circuit magnétique en forme de palette est représentée dans une position ouverte. Dans cette position, la partie mobile 10 est séparée de la partie fixe 9 par deux entrefers 12a et 12b situés à deux extrémités de ladite partie fixe. La distance des entrefers 12a et 12b est grande tant que la partie mobile est dans la position ouverte. La partie mobile est maintenue dans la position ouverte par un ressort de rappel 26 et par deux butées 27a et 27b.

Tant que le courant Ip circulant dans le conducteur primaire 6 est inférieur à une valeur SIp prédéterminée, la partie mobile 10 reste dans sa position ouverte. Puis, dès que le courant Ip du conducteur primaire dépasse le seuil de la valeur SIp prédéterminé, la partie mobile est attirée vers la partie fixe. Une variation importante du flux est alors créée dans le circuit magnétique. Cette variation de flux induit un courant secondaire (Is) dans l'enroulement 11 qui alimente le relais de déclenchement 7 pour provoquer l'ouverture des contacts 2.

Le seuil d'appel de la partie mobile vers la partie fixe dépend notamment de la distance des entrefers. Des organes de réglage, du seuil de la valeur SIp prédéterminée de courant, peuvent agir par exemple sur les butées pour faire varier la distance des entrefers.

La figure 3 montre des courbes illustrant le fonctionnement d'un transformateur selon un mode de réalisation de l'invention. Le courant primaire Ip croît rapidement dans une première partie C1 de la courbe, puis la croissance est plus faible dans une seconde partie C2. Si la croissance du courant Ip est rapide, la variation du courant induit dans le transformateur une variation de flux et un courant secondaire Is représenté par la partie C3 sur la courbe de Is. Lorsque le courant Ip dépasse un seuil prédéterminé SIp, la partie mobile 10 du circuit magnétique est attirée vers la partie fixe 9. Il se produit alors dans le circuit magnétique une variation de flux importante qui génère un courant secondaire Is élevé dans l'enroulement secondaire 11. Ce courant secondaire, représenté dans la partie C4 de la courbe de Is sur la figure 3, est fourni au relais 7 pour commander l'ouverture des contacts 2.

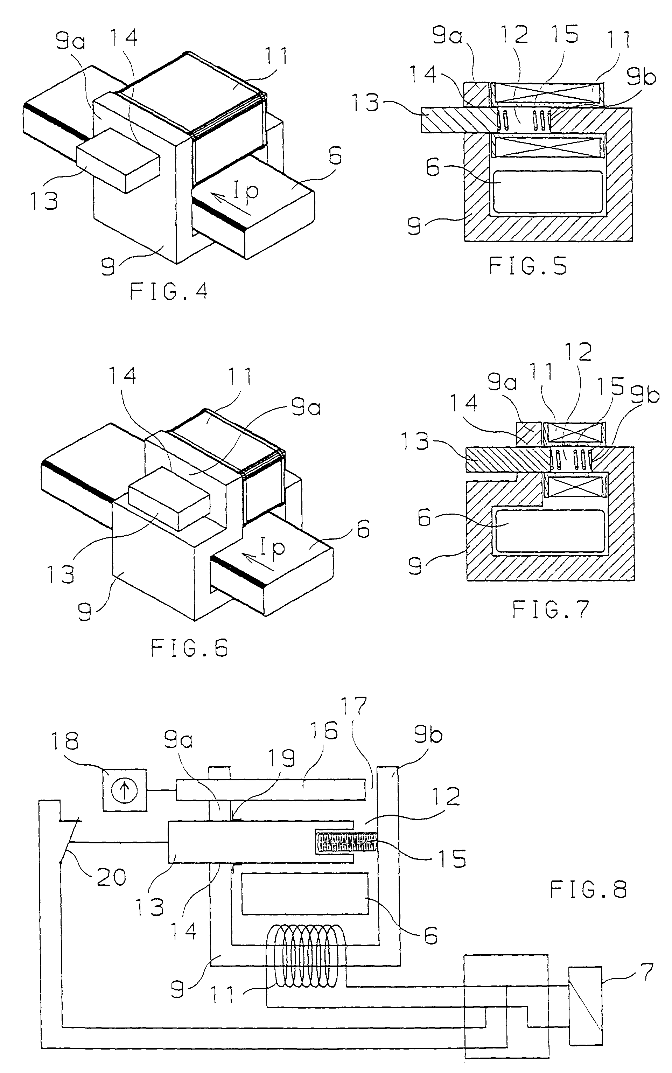

Dans des modes de réalisation préférentiels d'un transformateur selon l'invention, la partie mobile est un noyau 13 coulissant. Les figures 4 à 7 montrent des transformateurs comportant des parties mobiles à noyaux coulissants 13. Dans ces modes de réalisation, le noyau 13 coulisse dans une ouverture 14 d'une première partie fixe 9a du circuit magnétique et à l'intérieur d'une bobine de l'enroulement secondaire 11. Un ressort 15 est disposé entre une extrémité du noyau et une seconde partie fixe 9b du circuit magnétique pour maintenir un entrefer 12 entre la partie mobile 13 représentée par le noyau et ladite partie fixe 9b.

Le transformateur des figures 6 et 7 a une forme plus compacte que celui des figures 4 et 5. Ces différentes formes sont adaptées aux volumes réservés pour les transformateurs dans les disjoncteurs.
Le réglage de seuil prédéterminé agit, par exemple, sur la distance de l'entrefer 12 lorsque la partie mobile représentée par le noyau 13 est en position ouverte. Cependant, une modification de la distance d'entrefer risque de modifier aussi les valeurs des impulsions de courant secondaire Is. De plus, un réglage de la position du noyau peut s'avérer complexe selon la disposition des transformateurs dans le disjoncteur.

Dans des modes de réalisation d'un transformateur selon l'invention, le réglage de seuil est avantageusement réalisé au moyen d'un shunt magnétique à entrefer disposé en dérivation sur la partie mobile du circuit magnétique.

Un transformateur comportant un dispositif de réglage à shunt est représenté sur la figure 8. Le dispositif de réglage comporte un shunt 16 magnétique coulissant par rapport à une première partie fixe 9a du circuit magnétique est ayant un entrefer 17 par rapport à une seconde partie fixe 9b dudit circuit magnétique opposée à la première 9a.

Le shunt 16 est, par exemple, relié mécaniquement à des organes de réglage 18 d'un disjoncteur.

Dans ce transformateur, la partie mobile 13 avec son entrefer 12 et le shunt magnétique 16 avec son entrefer 17 sont disposés en parallèle entre la première partie fixe 9a et la seconde partie fixe 9b du circuit magnétique. La répartition du flux magnétique entre le shunt et le noyau dépend de la distance des entrefers respectivement 17 et 12. L'entrefer 12 de la partie mobile dans sa position ouverte, est déterminé par une butée 19 qui positionne le noyau lorsque le ressort 15 repousse ledit noyau vers la première partie fixe 9a.

Si le shunt est éloigné de la seconde partie fixe 9b, l'entrefer 17 a une distance élevée et le flux magnétique passe essentiellement par le noyau et l'entrefer 12. Le seuil d'attraction du noyau est alors bas, le courant secondaire est généré pour une valeur prédéterminée basse du courant primaire.

Dans le cas d'un réglage de seuil élevé, le shunt 16 est rapproché de la seconde partie fixe 9b. L'entrefer 17 a alors une distance réduite et une grande partie du flux magnétique passe par le shunt 17. Le champ magnétique dans l'entrefer 12 est plus faible. Pour attirer la partie mobile vers la partie fixe du circuit magnétique, le courant primaire Ip doit être plus élevé.

Lorsque le courant primaire varie sans que le seuil ne soit dépassé, il est préférable de ne pas alimenter le relais. Par exemple, sur la figure 3, la partie C1 du courant primaire Ip génère un courant secondaire Is représenté par la partie C3 de la courbe. Ce courant risque d'alimenter le relais alors que le seuil SIp n'est pas dépassé.

Pour éviter une commande du relais 7 en dehors d'un dépassement de seuil, le transformateur de la figure 8 comporte un détecteur de position 20 associé au noyau 13 de la partie mobile.

Le détecteur 20 est, par exemple, un contact électrique connecté au relais 7 ou à l'enroulement 11 pour inhiber la commande du relais par le courant secondaire Is tant que le noyau n'est pas attiré. Dans le schéma de la figure 8, le contact 20 est fermé tant que la partie mobile est en position ouverte. Dans cette position des courants Is générés dans l'enroulement 11 sont dérivés dans le contact 20 et le relais n'est pas commandé. Si le seuil est dépassé, la partie mobile 13 est attirée vers la partie fixe 9b et le contact 20 est ouvert. Le courant Is généré dans l'enroulement 11 par la variation de flux, due à l'attraction du noyau, est envoyé au relais 7 sans être court-circuité par le contact.

L'utilisation du détecteur 20 est aussi utile lorsque le transformateur est utilisé en courant alternatif. Le détecteur permet alors de différencier les courants alternatifs induits et les courants secondaires générés par le changement de position de la partie mobile.

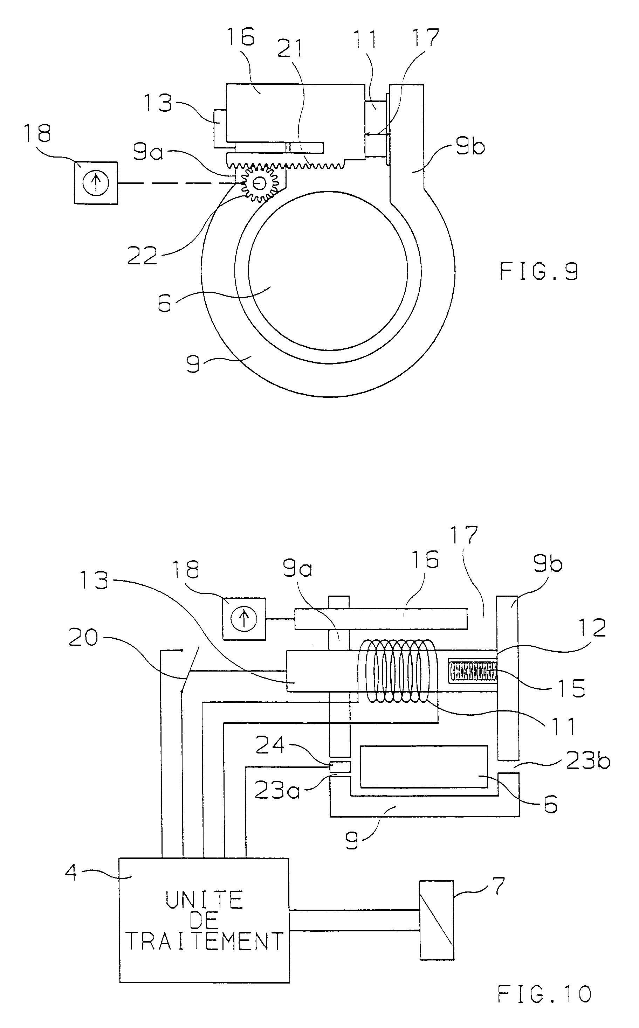

La figure 9 montre un mode de réalisation particulier d'un transformateur comportant un dispositif de réglage de seuil. Le circuit magnétique de ce transformateur a une forme sensiblement circulaire adaptée à la forme du conducteur primaire 6. Le noyau coulissant 13 coulisse à l'intérieur de la bobine de l'enroulement 11, et le shunt 16 est en parallèle sur l'ensemble noyau 13 et enroulement 11. Dans ce mode de réalisation, le shunt 16 comporte une partie dentée 21 en forme de crémaillère. L'organe de réglage 12 agit sur le shunt par l'intermédiaire d'une roue dentée 22 qui agit sur la partie dentée du shunt.

La figure 10 représente un schéma d'un autre mode de réalisation d'un transformateur selon l'invention. La partie fixe du circuit magnétique 9 du transformateur comporte des entrefers 23a, 23b pour réduire le flux magnétique circulant dans le circuit 9. Ces entrefers permettent d'éviter la saturation du circuit magnétique, notamment lorsqu'un fort courant Ip doit passer dans le conducteur primaire 6. Les entrefers 23a et 23b sont en série avec l'entrefer 12 de la partie mobile 13. Ils sont utilisés aussi pour déterminer le seuil de courant pour lequel l'attraction de la partie mobile se produit.

La partie mobile est représentée dans sa position fermée, l'entrefer 12 étant très petit ou nul.

Le transformateur représenté sur la figure 10 comporte aussi un capteur 24 sensible au champ magnétique inséré dans un entrefer 23a de la partie fixe 9 du circuit magnétique. Ce capteur 24, connecté à l'unité de traitement 4, est, de préférence, un capteur à effet Hall ou à magnétorésistance. Les signaux fournis par le capteur 24 à l'unité de traitement sont représentatifs du flux dans le circuit magnétique et du courant primaire Ip.

Sur la figure 10, le transformateur, l'unité de traitement et le relais forment un déclencheur. L'unité de traitement reçoit les signaux fournis par le capteur et commande le relais 7 si lesdits signaux dépassent des seuils prédéterminés pendant des temps prédéterminés. Pour ce type de fonctionnement, l'unité de traitement est alimentée par une alimentation auxiliaire. Les fonctions de déclenchement effectuées par l'unité de traitement sont, notamment, la protection thermique ou long retard, la protection court retard et la protection instantanée.

Pour assurer la protection court-retard ou la protection instantanée même sans alimentation auxiliaire, l'unité de traitement est connectée à l'enroulement secondaire 11 pour recevoir le courant secondaire de commande du relais 7. Un détecteur 20 de position peut aussi être connecté à l'unité de traitement pour empêcher la commande du relais par un courant secondaire Is tant que la partie fixe 13 n'est pas attirée.

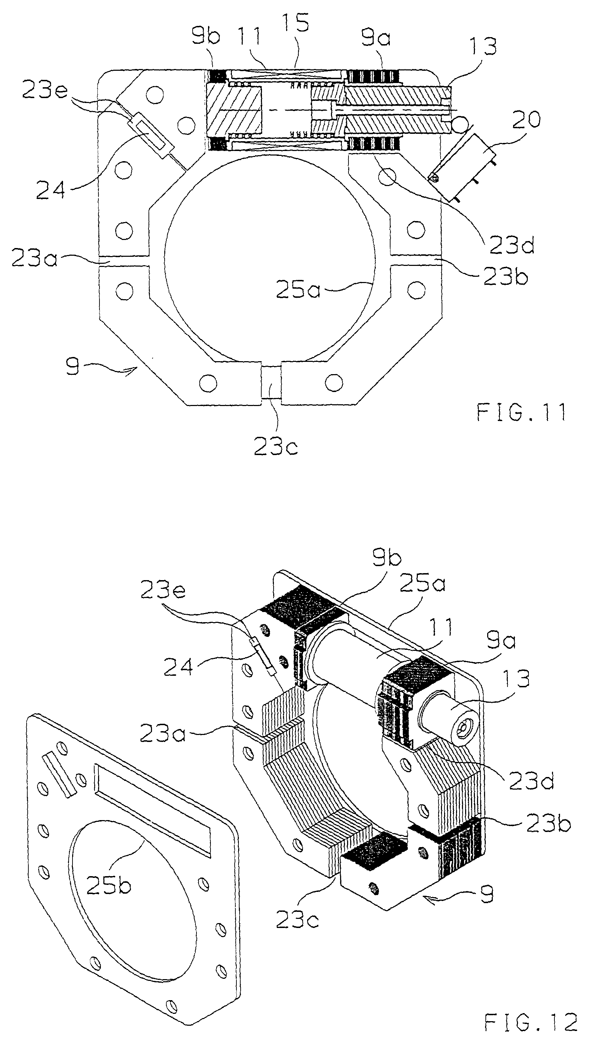

Les figures 11 et 12 montrent deux vues d'un transformateur selon un mode de réalisation de l'invention comportant plusieurs entrefers 23a, 23b, 23c, 23d et 23e répartis sur la partie fixe du circuit magnétique 9. La partie fixe étant découpée par des entrefers, le transformateur comporte deux flasques 25a et 25b pour maintenir ladite partie fixe.

L'entrefer 23e est destinée à recevoir un capteur 24. Il a une forme appropriée permettant de réduire le champ magnétique appliqué au capteur 24 lorsqu'un fort courant primaire doit passer par le conducteur 6.

Une première partie de l'entrefer a une distance élevée pour recevoir le capteur 24 et au moins une seconde partie, en parallèle sur la première, à une distance faible pour dériver du flux magnétique qui s'établit dans le circuit magnétique. Ainsi, en dérivant du flux magnétique par la seconde partie, le champ magnétique se trouvant dans la première partie comportant le capteur 24 est plus faible. Le capteur peut alors fournir un signal de mesure dans une grande étendue de fonctionnement. De plus, le champ dans l'entrefer est uniforme et le capteur ne nécessite plus un positionnement très précis dans l'entrefer pour garantir une réponse correcte.

Les transformateurs décrits ci-dessus sont bien adaptés aux protections de réseaux à courant continu, mais ils peuvent aussi être avantageusement utilisés pour la protection de réseaux alternatifs.

L'enroulement secondaire 11 peut comporter une ou plusieurs bobines disposées sur la partie fixe, la partie mobile ou les deux parties.

Les parties mobiles du circuit magnétique peuvent avoir d'autres formes que celles montrées sur les figures. Par exemple, ces parties peuvent aussi avoir des formes de palettes pivotant autour d'un axe.
Dans des transformateurs selon les figures 10, 11 ou 12, le réglage de seuil peut aussi être réalisé en faisant varier au moins un entrefer de la partie fixe du circuit magnétique, ou la tension du ressort de rappel.

## Revendications

1. Transformateur de courant comportant un circuit magnétique (8) associé à un conducteur (6) primaire, et un enroulement (11) secondaire destiné à fournir un courant (Is) secondaire pour actionner un relais (7) de déclenchement,
transformateur caractérisé en ce que le circuit magnétique comporte une partie mobile (10, 13) et une partie fixe (9, 9a, 9b), la partie mobile ayant une première position ouverte ouvrant le circuit magnétique avec un entrefer (12, 12a, 12b) de distance élevée et une seconde position fermée fermant le circuit magnétique avec un entrefer petit ou nul, ladite partie mobile passant de la première position ouverte à la seconde position fermée lorsqu'un courant primaire (Ip) circulant dans le conducteur primaire dépasse une valeur (SIp) prédéterminée.

2. Transformateur de courant selon la revendication 1 caractérisé en ce qu'il comporte des moyens de réglage comportant un shunt magnétique (16) à entrefer (17) disposé en dérivation sur la partie (10, 13) mobile du circuit magnétique.

3. Transformateur de courant selon l'une des revendications 1 ou 2 caractérisé en ce que la partie mobile est une palette (10) reliée à un ressort (26) de rappel, ladite palette étant positionnée dans sa première position ouverte par des moyens (27a, 27b) d'appui, et positionnée dans sa seconde position fermée en contact avec une partie (9) fixe du circuit magnétique.

4. Transformateur de courant selon l'une des revendications 1 ou 2 caractérisé en ce que la partie mobile est un noyau (13) coulissant par rapport à une première partie (9a) fixe du circuit magnétique, ledit noyau ayant un entrefer (12) de distance élevée par rapport à une seconde partie (9b) fixe du circuit magnétique lorsqu'il est dans sa première position ouverte et un entrefer faible ou nul par rapport à ladite seconde partie fixe lorsqu'il est dans sa seconde position fermée.

5. Transformateur de courant selon la revendication 4 caractérisé en ce que une bobine de l'enroulement (11) secondaire est disposée autour du noyau (13) coulissant.

6. Transformateur de courant selon l'une quelconque des revendications 1 à 5 caractérisé en ce que le circuit magnétique comporte des entrefers (23a-23e) répartis.

7. Déclencheur caractérisé en ce qu'il comporte au moins un transformateur selon l'une quelconque des revendications 1 à 6 et un relais (7) de déclenchement connecté à un enroulement (11) secondaire dudit transformateur.

8. Déclencheur selon la revendication 7 caractérisé en ce qu'il comporte des moyens (20) de détection associés au transformateur pour détecter le déplacement de la partie mobile (10, 13) du circuit magnétique, lesdits moyens (20) étant connectés au relais de déclenchement pour contrôler l'actionnement du relais (7) lorsqu'un courant (Is) secondaire est fourni par le transformateur.

9. Déclencheur selon l'une des revendications 7 ou 8 caractérisé en ce qu'il comporte une unité (4) de traitement connectée au relais (7) de déclenchement et, des moyens (24) de mesure, associés au transformateur et connectés à l'unité de traitement, fournissant un signal représentatif d'un courant (Ip) circulant dans le conducteur primaire.

10. Disjoncteur caractérisé en ce qu'il comporte au moins un transformateur selon l'une quelconque des revendications 2 à 6, et des organes (18) de réglage reliés au transformateur pour régler la valeur (SIp) de courant prédéterminée pour laquelle la partie (10, 13) mobile passe de sa première position ouverte à sa seconde position fermée.

## Patentansprüche

1. Stromwandler mit einem, einem Primärleiter (6) zugeordneten Magnetkreis (8) sowie einer Sekundärwicklung (11), die dazu dient, einen Sekundärstrom (Is) zur Betätigung eines Auslöserelais (7) zu liefern,
dadurch gekennzeichnet, daß der Magnetkreis einen beweglichen Teil (10, 13) und einen feststehenden Teil (9, 9a, 9b) umfaßt, welcher bewegliche Teil eine erste Offenstellung entsprechend einem offenen Magnetkreis mit einem breiten Luftspalt (12, 12a, 12b) sowie eine zweite Schließstellung entsprechend einem geschlossenen Magnetkreis mit einem kleinen oder keinem Luftspalt aufweist, wobei der bewegliche Teil von der ersten Offenstellung in die zweite Schließstellung übergeht, wenn ein im Primärleiter fließender Primärstrom (Ip) einen festgelegten Wert (SIp) überschreitet.

2. Stromwandler nach Anspruch 1, dadurch gekennzeichnet, daß er Einstellmittel umfaßt, die ein parallel zum beweglichen Teil (10, 13) des Magnetkreises angeordnetes magnetisches Nebenschlußeisen (16) mit Luftspalt (17) umfassen.

3. Stromwandler nach einem der Ansprüche 1 oder 2, dadurch gekennzeichnet, daß der bewegliche Teil als mit einer Rückstellfeder (26) verbundener Magnetanker (10) ausgebildet ist, welcher Magnetanker durch Stützmittel (27a, 27b) in seiner ersten Offenstellung positioniert wird und in seiner Schließstellung an einem feststehenden Teil (9) des Magnetkreises anliegt.

4. Stromwandler nach einem der Ansprüche 1 oder 2, dadurch gekennzeichnet, daß der bewegliche Teil als in bezug auf einen ersten feststehenden Teil (9a) des Magnetkreises verschiebbarer Magnetkern (13) ausgebildet ist, welcher Kern in seiner ersten Offenstellung einen Luftspalt (12) großer Breite in bezug auf einen zweiten feststehenden Teil (9b) und in seiner zweiten Schließstellung einen schmalen bzw. keinen Luftspalt in bezug auf den genannten zweiten feststehenden Teil aufweist.

5. Stromwandler nach Anspruch 4, dadurch gekennzeichnet, daß eine Spule der Sekundärwicklung (11) um den Schiebekern (13) geführt ist.

6. Stromwandler nach irgendeinem der Ansprüche 1 bis 5, dadurch gekennzeichnet, daß der Magnetkreis mehrere verteilte Luftspalte (23a-23e) aufweist.

7. Auslöser dadurch gekennzeichnet, daß er mindestens einen Stromwandler nach irgendeinem der Ansprüche 1 bis 6 sowie ein mit einer Sekundärwicklung (11) des genannten Stromwandlers verbundenes Auslöserelais (7) umfaßt.

8. Auslöser nach Anspruch 7, dadurch gekennzeichnet, daß er dem Stromwandler zugeordnete Erfassungsmittel (20) zur Erfassung einer Lageänderung des beweglichen Teils (10, 13) des Magnetkreises umfaßt, welche genannten Mittel (20) mit dem Auslöserelais verbunden sind, um die Betätigung des Relais (7) zu bewirken, wenn der Stromwandler einen Sekundärstrom (Is) liefert.

9. Auslöser nach einem der Ansprüche 7 oder 8, dadurch gekennzeichnet, daß er eine an das Auslöserelais (7) angeschlossene Verarbeitungseinheit (4) sowie dem Stromwandler zugeordnete und an die Verarbeitungseinheit angeschlossene Meßmittel (24) umfaßt, die ein den Strom (Ip) im Primärleiter abbildendes Signal liefern.

10. Leistungsschalter, dadurch gekennzeichnet, daß er mindestens einen Stromwandler nach irgendeinem der Ansprüche 2 bis 6 sowie mit dem Stromwandler verbundene Einstellmittel (18) zur Einstellung des festgelegten Stromwerts (SIp) umfaßt, bei dem der bewegliche Teil (10, 13) von seiner ersten Offenstellung in seine zweite Schließstellung übergeht.

## Claims

1. A current transformer comprising a magnetic circuit (8) associated to a primary conductor (6), and a secondary winding (11) designed to supply a secondary current (Is) to actuate a trip relay (7),
a transformer characterized in that the magnetic circuit comprises a movable part (10, 13) and a stationary part (9, 9a, 9b), the movable part having a first open position opening the magnetic circuit with an air-gap (12, 12a, 12b) of large distance and a second closed position closing the magnetic circuit with a small or zero air-gap, said movable part moving from the first open position to the second closed position when a primary current (Ip) flowing in the primary conductor exceeds a preset value (SIp).

2. The current transformer according to claim 1 characterized in that it comprises adjustment means comprising a magnetic shunt (16) with an air-gap (17) branch connected on the movable part (10, 13) of the magnetic circuit.

3. The current transformer according to claim 1 or 2 characterized in that the movable part is a blade (10) connected to a return spring (26), said blade being positioned in its first open position by bearing means (27a, 27b) and positioned in its second closed position in contact with a stationary part (9) of the magnetic circuit.

4. The current transformer according to claim 1 or 2 characterized in that the movable part is a plunger (13) sliding with respect to a first stationary part (9a) of the magnetic circuit, said plunger having an air-gap (12) of large distance with respect to a second stationary part (9b) of the magnetic circuit when it is in its first open position and a small or zero air-gap with respect to said second stationary part of the magnetic circuit when it is in its second closed position.

5. The current transformer according to claim 4 characterized in that a coil of the secondary winding (11) is arranged around the sliding plunger (13).

6. The current transformer according to any one of the claims 1 to 5 characterized in that the magnetic circuit comprises distributed air-gaps (23a-23e).

7. A trip device characterized in that it comprises at least one transformer according to any one of the claims 1 to 6 and a trip relay (7) connected to a secondary winding (11) of said transformer.

8. The trip device according to claim 7 characterized in that it comprises means (20) for detection associated to the transformer to detect movement of the movable part (10, 13) of the magnetic circuit, said means (20) being connected to the trip relay to control actuation of the relay (7) when a secondary current (Is) is supplied by the transformer.

9. The trip device according to one of the claims 7 or 8 characterized in that it comprises a processing unit (4) connected to the trip relay (7), and measuring means (24), associated to the transformer and connected to the processing unit, supplying a signal representative of a current (Ip) flowing in the primary conductor.

10. A circuit breaker characterized in that it comprises at least one transformer according to any one of the claims 2 to 6, and adjustment devices (18) connected to the transformer to adjust the preset current value (SIp) for which the movable part (10, 13) moves from its first open position to its second closed position.
